# EUROPÄISCHE PATENTSCHRIFT

(11) **EP 4 513 145 B1**
(45) Veröffentlichungstag und Bekanntmachung des Hinweises auf die Patenterteilung: **26.08.2026**
(21) Anmeldenummer: 24184014.9
(22) Anmeldetag: 24.06.2024
(51) Int. Cl.: G01D 3/08, G01D 5/244

(54) **SCHALTUNGSANORDNUNG MIT DIAGNOSEFUNKTION FÜR ASICS UND VERFAHREN ZUR DIAGNOSE VON ASICS**
CIRCUIT ARRANGEMENT WITH DIAGNOSIS FUNCTION FOR ASIC AND METHOD FOR DIAGNOSIS OF ASIC
CIRCUIT AVEC FONCTION DE DIAGNOSTIC POUR ASICS ET PROCÉDÉ DE DIAGNOSTIC D'ASICS

(30) Priorität: 23.08.2023 DE 102023208060
(43) Veröffentlichungstag der Anmeldung: 26.02.2025
(73) Patentinhaber: Dr. Johannes Heidenhain GmbH, 83301 Traunreut (DE)
(72) Erfinder: MAYER, Elmar, 83365 Nußdorf (DE); BEH, Mitja, 83275 Traunstein (DE); von BERG, Martin, 83236 Übersee (DE); OBERHAUSER, Johann, 83377 Vachendorf (DE); OCHSENBRÜCHER, Ralf, 83355 Grabenstätt (DE)

(56) Entgegenhaltungen:
- EP-A2- 1 049 050
- DE-A1- 102019 132 278
- DE-A1- 19 933 924
- US-A1- 2022 162 061

## Beschreibung

### GEBIET DER TECHNIK

Die vorliegende Erfindung betrifft eine Schaltungsanordnung für ASICs nach Anspruch 1 und Verfahren zur Diagnose von ASICs nach Anspruch 8. Weiter betrifft die Erfindung ein Positionsmessgerät nach Anspruch 15.

### STAND DER TECHNIK

Mit fortschreitender Digitalisierung in der Automatisierungstechnik, die durch Industrie 4.0 erforderlich wird, steigt auch die Komplexität von Messgeräten der Automatisierungstechnik, wie beispielsweise Drehgebern und Längenmessgeräten. Um den Platzbedarf der hieraus resultierenden umfangreichen elektronischen Schaltungen zu minimieren, gibt es einen Trend, immer mehr Funktionsgruppen der elektronischen Schaltungen in anwendungsspezifische integrierte Bausteine (ASICs) zu integrieren.

So beschreibt die DE 10 2008 051 083 A1 einen getriebebasierten Multiturn-Drehgeber mit einer Singleturn-Stufe mit einer Singleturn-Abtasteinheit zur Messung der Winkelstellung einer Welle, sowie einer Mehrzahl von Multiturn-Stufen mit je einer Multiturn-Abtasteinheit zur Bestimmung der Anzahl zurückgelegter Umdrehungen der Welle. Sowohl die Singleturn-Abtasteinheit als auch jede Multiturn-Abtasteinheit können einen ASIC umfassen.

Eine weitere Forderung von Industrie 4.0 ist die Fähigkeit der Messgeräte zur eigenständigen Feststellung der Funktionsbereitschaft. Aus diesem Grund werden ASICs häufig mit Selbstdiagnosefunktionen ausgestattet. Diese basieren darauf, Funktionsparameter der integrierten elektronischen Schaltung zu messen und die Messergebnisse auszuwerten. Das Ergebnis der Auswertung wird dann von den einzelnen ASICs der Schaltung an jeweils eine zentrale Stelle ausgegeben und dort wird dann die Funktionsbereitschaft der Gesamtschaltung ermittelt. Um die Selbstdiagnosefunktionen der ASICs zu realisieren, ist aber eine weiterer erheblicher Schaltungsaufwand nötig, der zu einer noch höheren Komplexität dieser Bausteine führt.

Aus der US 2022/162061 A1 sind adaptive MEMS-Bauelemente bekannt.

### ZUSAMMENFASSUNG DER ERFINDUNG

Es ist eine Aufgabe der vorliegenden Erfindung, eine verbesserte Schaltungsanordnung zur Feststellung der Funktionsbereitschaft einer Schaltung mit einer Mehrzahl von ASICs zu schaffen.

Diese Aufgabe wird gelöst durch eine Schaltungsanordnung, insbesondere für die Verwendung in Positionsmessgeräten, nach Anspruch 1.

Die Schaltungsanordnung umfasst einen übergeordneten ASIC mit einer elektronischen Schaltung zur Ausführung einer bestimmungsgemäßen Funktion und wenigstens einen untergeordneten ASIC mit einer elektronischen Schaltung zur Ausführung einer bestimmungsgemäßen Funktion, wobei der wenigstens eine untergeordnete ASIC eine Parametermesseinheit und der übergeordnete ASIC eine Diagnoseeinheit umfasst, die über einen Datenübertragungskanal miteinander verbunden sind und wobei die Parametermesseinheit ausgestaltet ist, um eine Mehrzahl von Funktionsparametern der elektronischen Schaltung des untergeordneten ASICs zu ermitteln und über den Datenübertragungskanal zur Diagnoseeinheit zu übertragen und die Diagnoseeinheit ausgestaltet ist, durch Auswertung der Funktionsparameter die Funktionsbereitschaft der elektronischen Schaltung des jeweiligen untergeordneten ASICs festzustellen.

Weiter ist es Aufgabe der vorliegenden Erfindung, ein verbessertes Verfahren zur Feststellung der Funktionsbereitschaft einer Schaltung mit einer Mehrzahl von ASICs zu schaffen.

Dies Aufgabe wird gelöst durch ein Verfahren zum Betreiben einer Schaltungsanordnung, insbesondere für die Verwendung in Positionsmessgeräten, nach Anspruch 8.

Die dem Verfahren zugrundeliegende Schaltungsanordnung umfasst einen übergeordneten ASIC mit einer elektronischen Schaltung zur Ausführung einer bestimmungsgemäßen Funktion und wenigstens einen untergeordneten ASIC mit einer elektronischen Schaltung zur Ausführung einer bestimmungsgemäßen Funktion, wobei der wenigstens eine untergeordnete ASIC eine Parametermesseinheit und der übergeordnete ASIC eine Diagnoseeinheit umfasst, die über einen Datenübertragungskanal miteinander verbunden sind. Gemäß dem vorgeschlagenen Verfahren wird von der Parametermesseinheit eine Mehrzahl von Funktionsparametern der elektronischen Schaltung des untergeordneten ASICs ermittelt und über den Datenübertragungskanal zur Diagnoseeinheit übertragen und von der Diagnoseeinheit wird durch Auswertung der Funktionsparameter die Funktionsbereitschaft der elektronischen Schaltung des jeweiligen untergeordneten ASICs festgestellt.

Eine weitere Aufgabe der vorliegenden Erfindung ist es, ein Positionsmessgerät mit einer verbesserten Möglichkeit zur Feststellung der Funktionsbereitschaft zu schaffen.

Diese Aufgabe wird gelöst durch ein Positionsmessgerät nach Anspruch 15.

Weitere Vorteile der vorliegenden Erfindung ergeben sich aus den von den unabhängigen Ansprüchen 1 und 8 abhängigen Ansprüchen, sowie aus der folgenden Beschreibung der Ausführungsbeispiele.

### KURZE BESCHREIBUNG DER ZEICHNUNGEN

Es zeigt
- Figur 1: ein erstes Ausführungsbeispiel einer erfindungsgemäßen Schaltungsanordnung in Verbindung mit einem Multiturn-Drehgeber,
- Figur 2: ein Ablaufdiagramm eines erfindungsgemäßen Verfahrens,
- Figur 3: ein Blockschaltbild einer erfindungsgemäßen Parametermesseinheit,
- Figur 4: ein Blockschaltbild einer erfindungsgemäßen Diagnoseeinheit,
- Figur 5: ein zweites Ausführungsbeispiel einer erfindungsgemäßen Schaltungsanordnung in Verbindung mit einem Multiturn-Drehgeber und
- Figur 6: ein drittes Ausführungsbeispiel einer erfindungsgemäßen Schaltungsanordnung in Verbindung mit einem Singleturn-Drehgeber mit Zusatzsensoren.

### BESCHREIBUNG DER AUSFÜHRUNGSFORMEN

In der nachfolgenden Beschreibung vorteilhafter Ausführungsformen bleiben die Bezugszeichen von Komponenten, deren Funktion bereits anhand einer Figur beschrieben wurden, in nachfolgenden Figuren unverändert. Gestrichelte Linien deuten jeweils vorteilhafte Varianten einer Ausführungsform an, auf die in der Beschreibung hingewiesen wird.

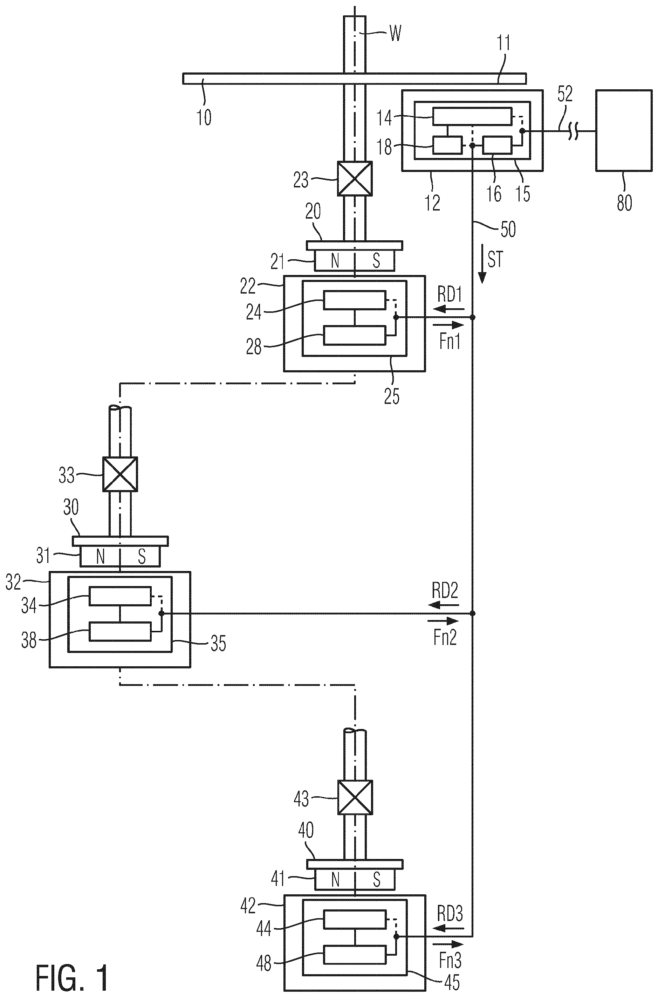

Figur 1 zeigt ein erstes Ausführungsbeispiel einer erfindungsgemäßen Schaltungsanordnung in Verbindung mit einem Multiturn-Drehgeber. Der Multiturn-Drehgeber weist im Wesentlichen eine Singleturn-Messanordnung zur Messung eines Positionswertes, der die Winkelposition einer Welle W angibt und eine Multiturn-Messanordnung zum Zählen der von der Welle W zurückgelegten Umdrehungen auf.

Die Singleturn-Messanordnung besteht aus einer Singleturn-Codescheibe 10, deren Mittelpunkt M drehfest mit der zu messenden Welle verbunden ist und eine konzentrisch zum Mittelpunkt M angeordnete ringförmige Codespur 11 trägt. Ferner ist zum Ablesen der Codespur 11 und zur Ermittlung des absoluten Positionswertes entsprechend der Winkelstellung der Singleturn-Codescheibe 10 ein Singleturn-Positionsaufnehmer 12 vorgesehen. Wird zur Positionserfassung ein optisches Abtastprinzip eingesetzt, besteht die Codespur 11 beispielsweise aus einem Strichmuster aus Bereichen mit verschiedenen optischen Eigenschaften, beispielsweise lichtdurchlässig/lichtundurchlässig, oder reflektierend/nicht reflektierend. Licht aus einer Lichtquelle wird in Richtung der Codespur 11 ausgesandt, von dieser moduliert und trifft schließlich auf Fotodetektoren, die mit Vorteil im Singleturn-Positionsaufnehmer 12 angeordnet sind. Auf die Darstellung einer Lichtquelle wurde hier aus Gründen der Übersichtlichkeit verzichtet. Die Codespur 11 kann absolut codiert oder/und inkremental ausgeführt sein und gegebenenfalls aus mehreren, nebeneinander angeordneten Teilungsspuren bestehen.

Alternativ kann anstatt des optischen Abtastprinzips auch ein induktives, magnetisches oder kapazitives Abtastprinzip eingesetzt werden.

Zur Messung von Umdrehungsdaten, die zur Ermittlung der Anzahl der zurückgelegten Umdrehungen der Welle W geeignet sind, dient die Multiturn-Messanordnung. Sie umfasst im dargestellten Beispiel drei Multiturn-Stufen. Jede dieser Multiturn-Stufen umfasst eine Multiturn-Codescheibe 20, 30, 40 mit je einem Codeelement 21, 31, 41, sowie einen Multiturn-Positionsaufnehmer 22, 32, 42 zur Messung der Winkelposition der Codeelemente 21, 31, 41. Die Multiturn-Codescheiben 20, 30, 40 werden von der zu messenden Welle W über ein dreistufiges Untersetzungsgetriebe 23, 33, 43 angetrieben, wobei bei Drehung der Welle W die erste Multiturn-Codescheibe 20, die von der ersten Getriebestufe 23 angetrieben wird, die höchste und die dritte Multiturn-Codescheibe 40, die von der dritten und zugleich letzten Getriebestufe 43 angetrieben wird, die niedrigste Drehzahl aufweist. Das Untersetzungsverhältnis der Getriebestufen 23, 33, 43 beträgt beispielsweise 16:1, d.h. aus je sechzehn Umdrehungen der Eingangswelle der jeweiligen Getriebestufe 23, 33, 43 resultiert eine Umdrehung der Ausgangswelle.

Zur Realisierung der Multiturn-Stufen wird häufig ein magnetisches Abtastprinzip eingesetzt. In diesem Fall bestehen die Codeelemente 21, 31, 41 aus scheibenförmigen Permanentmagneten, die mit den Multiturn-Codescheiben 20, 30, 40 drehfest verbunden sind und die je einen Dipol, d.h. einen magnetischen Nordpol N und Südpol S aufweisen. Die Abtastung der Dipole zur Ermittlung der Winkelposition der Codeelemente 21, 31, 41 erfolgt mittels in den jeweiligen Multiturn-Positionsaufnehmern 22, 32, 42 angeordneten Magnetsensoren (z.B. Hall-Sensoren, MR-Sensoren, ...). Die Auflösung der Multiturn-Positionsaufnehmer 22, 32, 42 beträgt beispielsweise 8 Bit, d.h. eine Umdrehung der Multiturn-Codescheiben 20, 30, 40 wird mit 256 absoluten Positionswerten aufgelöst und in Form von Datenwörtern bereitgestellt. Durch Kombination der Datenwörter ist wiederum die Anzahl der zurückgelegten Umdrehungen der Welle W ermittelbar.

Alternativ kann anstatt des magnetischen Abtastprinzips auch ein induktives, optisches oder kapazitives Abtastprinzip eingesetzt werden.

Die Kombination der Positionswerte der Singleturn-Messanordnung und der Datenwörter der Multiturn-Stufen zu einem Gesamtpositionswert, der sowohl die Winkelposition der Welle W, als auch die Anzahl der zurückgelegten Umdrehungen der Welle W umfasst, erfolgt im Singleturn-Positionsaufnehmer 12.

Darüber hinaus ist der Singleturn-Positionsaufnehmer 12 ausgestaltet zur Kommunikation mit einer Folgeelektronik 80 über einen externen Datenübertragungskanal 52. Die Kommunikation umfasst beispielsweise die Ausgabe des Gesamtpositionswerts an die Folgeelektronik 80.

Eine wesentliche Komponente des Singleturn-Positionsaufnehmers 12 ist ein anwendungsspezifischer integrierter Baustein (ASIC), in dem eine elektronische Schaltung 14 einer Mehrzahl von wesentlichen Funktionsblöcken des Singleturn-Positionsaufnehmers 12 integriert ist. Beispielhaft seien an dieser Stelle die Fotodetektoren, eine Auswerteelektronik, eine Ausgabeschnittstelle, eine interne Schnittstelle, sowie eine Kombinationseinheit genannt. Die elektronische Schaltung 14 dient der Ausführung der bestimmungsgemäßen Funktionen des ASICs. Im Rahmen dieses Ausführungsbeispiels wird dieser ASIC als übergeordneter ASIC 15 bezeichnet.

Bestimmungsbemäße Funktionen des übergeordneten ASICs 15 sind in diesem Ausführungsbeispiel beispielsweise
- Bestimmung von absoluten Positionswerten,
- Bestimmung des Gesamtpositionswerts und
- Kommunikation mit der Folgeelektronik 80.

Auch jeder Multiturn-Positionsaufnehmer 22, 32, 42 besteht im Wesentlichen aus einem anwendungsspezifischen integrierten Baustein (ASIC), in dem eine elektronische Schaltung 24, 34, 44 einer Mehrzahl von wesentlichen Funktionsblöcken des jeweiligen Multiturn-Positionsaufnehmers 22, 32, 42 integriert ist. In diesem Beispiel können das die Magnetsensoren, eine Auswerteelektronik und eine Ausgabeschnittstelle sein. Diese elektronische Schaltung 24, 34, 44 dient der Ausführung der bestimmungsgemäßen Funktionen des ASICs. Im Rahmen dieses Ausführungsbeispiels werden diese ASICs als untergeordnete ASICs 25, 35, 45 bezeichnet.

Eine bestimmungsgemäße Funktion der untergeordneten ASICs 25, 35, 45 ist in diesem Ausführungsbeispiel die Bestimmung der Datenwörter, die die absolute Winkelstellung der jeweiligen Multiturn-Codescheiben 20, 30, 40 angeben.

Der übergeordnete ASIC 15 ist mit den untergeordneten ASICs 25, 35, 45 zum Zwecke der Kommunikation über wenigstens einen Datenübertragungskanal 50 verbunden. Als Datenübertragungskanal 50 können beliebige Schnittstellenverbindungen zum Einsatz kommen, die eine bidirektionale Übertragung digitaler Daten ermöglichen. Geeignet sind sowohl Punkt-zu-Punkt- als auch Busschnittstellen. Es kann eine serielle oder eine parallele Datenübertragung zum Einsatz kommen. In einer bevorzugten Ausführungsform ist der Datenübertragungskanal 50 durch eine bidirektionale serielle Schnittstelle, insbesondere eine I2C-Schnittstelle, gebildet.

Erfindungsgemäß weist der übergeordnete ASIC 15 eine Diagnoseeinheit 16 und jeder untergeordnete ASIC 25, 35, 45 eine Parametermesseinheit 28, 38, 48 auf. Die Diagnoseeinheit 16 ist ausgestaltet zur Kommunikation mit den Parametermesseinheiten 28, 38, 48 über den Datenübertragungskanal 50.

Mit Vorteil erfolgt über den Datenübertragungskanal 50 auch die Kommunikation zwischen der elektronischen Schaltung 14 des übergeordneten ASICs 15 und der elektronischen Schaltung 24, 34, 44 der untergeordneten ASICs 25, 35, 45, so dass nur eine Schnittstellenverbindung für die gesamte Kommunikation zwischen dem übergeordneten ASIC 15 und den untergeordneten ASICs 25, 35, 45 vorgesehen werden muss.

Jede Parametermesseinheit 28, 38, 48 ist geeignet ausgestaltet, um eine Mehrzahl von Funktionsparametern Fn1, Fn2, Fn3 des jeweiligen untergeordneten ASICs 25, 35, 45 zu ermitteln, insbesondere durch Messung. Funktionsparameter sind hierbei Parameter, die einen Rückschluss auf eine ordnungsgemäße Funktion der elektronischen Schaltung 24, 34, 44 des untergeordneten ASICs 25, 35, 45 erlauben, beispielsweise
- Spannungswerte an definierten Messpunkten der elektronischen Schaltung 24, 34, 44 des untergeordneten ASICs 25, 35, 45,
- die Stromaufnahme von Teilschaltungen oder/und der gesamten elektronischen Schaltung 24, 34, 44 des untergeordneten ASICs 25, 35, 45,
- Widerstandswerte,
- Kennwerte digitaler Signale wie Flankenabstände, Frequenz, Tastverhältnis, Jitter, etc.,
- Verarbeitungszeit von Teilschaltungen der elektronischen Schaltung 24, 34, 44 des untergeordneten ASICs 25, 35, 45.

Für die Ermittlung der Funktionsparameter Fn1, Fn2, Fn3 umfasst die Parametermesseinheit 28, 38, 48 geeignete Messmittel, beispielsweise A/D-Wandler, Zeitmesser (insbesondere Zähler), Komparatoren. Weiter kann die Parametermesseinheit 28, 38, 48 Signalerzeuger umfassen, beispielsweise Strom- und/oder Spannungsquellen, Taktgeneratoren, D/A-Wandler. Ebenso kann die Parametermesseinheit 28, 38, 48 Schaltmittel umfassen, um die Messmittel und/oder die Signalerzeuger mit Knotenpunkten der elektronischen Schaltung 24, 34, 44 des untergeordneten ASICs 25, 35, 45 zu verbinden. Die Messmittel, Signalerzeuger und Schaltmittel können ausschließlich der Parametermesseinheit 28, 38, 48 zugeordnet sein, oder zumindest teilweise, nur zum Zwecke der Durchführung der Selbsttestfunktion der Parametermesseinheit 28, 38, 48 zugeordnet werden und ansonsten der Ausführung der bestimmungsgemäßen Funktion der untergeordneten ASICs 25, 35, 45 dienen. Im letzteren Fall handelt es sich um Teilschaltungen der elektronischen Schaltung 24, 34, 44.

Die Ermittlung der Funktionsparameter Fn1, Fn2, Fn3 wird mit Vorteil nach dem Empfang eines Selbsttest-Startbefehls ST gestartet, der über den Datenübertragungskanal 50 bei den untergeordneten ASICs 25, 35, 45 eintrifft.

Die ermittelten Funktionsparameter Fn1, Fn2, Fn3 sind über den Datenübertragungskanal 50 zum übergeordneten ASIC 15 übertragbar. Mit Vorteil erfolgt die Übertragung nicht unmittelbar nach der Ermittlung, sondern es ist in den Parametermesseinheiten 28, 38, 48 ein Speicher vorgesehen, in dem die Funktionsparameter Fn1, Fn2, Fn3 speicherbar sind. Die Übertragung erfolgt dann als Folge des Empfangs eines Datenanforderungsbefehls RD1, RD2, RD3, der vom übergeordneten ASIC 15 über den Datenübertragungskanal zum jeweiligen untergeordneten ASIC 25, 35, 45 gesendet wird.

Der Zeitpunkt, ab dem die ermittelten Funktionsparameter Fn1, Fn2, Fn3 im jeweiligen untergeordneten ASIC 25, 35, 45 zur Verfügung stehen, kann im einfachsten Fall durch Abwarten einer definierten Zeitdauer ermittelt werden. Alternativ können spezielle Befehle vorgesehen sein, über die der übergeordnete ASIC 15 über den Datenübertragungskanal 50 den Status der Ermittlung der Funktionsparameter Fn1, Fn2, Fn3 von den untergeordneten ASICs 25, 35, 45 anfordern kann ("Polling"). Als weitere Alternative kann vorgesehen sein, dass die untergeordneten ASICs 25, 35, 45 durch Senden einer Abschlussmeldung über den Datenübertragungskanal 50 anzeigen, dass die Funktionsparameter Fn1, Fn2, Fn3 zur Verfügung stehen.

Im übergeordneten ASIC 15 sind die Funktionsparameter Fn1, Fn2, Fn3 der Diagnoseeinheit 16 zuführbar, die geeignet ausgestaltet ist, durch Auswertung der Funktionsparameter Fn1, Fn2, Fn3 die Funktionsbereitschaft des jeweiligen untergeordneten ASICs 25, 35, 45 zu beurteilen. Die Auswertung kann die Prüfung, ob einzelne Funktionsparameter, oder/und voneinander abhängige Funktionsparameter, innerhalb vorgegebener Grenzwerte liegen, umfassen. Ergibt die Auswertung, dass jeder der untergeordneten ASICs 25, 35, 45 funktionsbereit ist, wird in einen Normalbetrieb übergegangen, andernfalls in einen Fehlerbetrieb.

In an sich bekannter Weise kann der übergeordnete ASIC 15 ebenfalls eine Parametermesseinheit 18 umfassen. Diese dient der Ermittlung von internen Funktionsparametern des übergeordneten ASICs 15, die, äquivalent zu den Funktionsparametern Fn1, Fn2, Fn3 der untergeordneten ASICs 25, 35, 45, in einer Diagnoseeinheit ausgewertet werden. Der übergeordnete ASIC 15 weist in diesem Fall eine Selbstdiagnosefunktion auf. Die Diagnoseeinheit kann die Diagnoseeinheit 16 sein, in der auch die Funktionsparameter Fn1, Fn2, Fn3 der untergeordneten ASICs 25, 35, 45 ausgewertet werden. Der übergeordnete ASIC 15 kann hierfür aber auch eine zusätzliche Diagnoseeinheit umfassen.

Das Ergebnis der Auswertung der Funktionsparameter Fn1, Fn2, Fn3 der untergeordneten ASICs 25, 35, 45 und ggf. des übergeordneten ASICs 15, wird in einer Statusinformation STAT gespeichert. Diese ist über den externen Datenübertragungskanal 52 an die Folgeelektronik 80 ausgebbar und dadurch die Funktionsbereitschaft des Multiturn-Drehgebers anzeigbar.

Bei der Folgeelektronik 80 handelt es sich um ein externes, eigenständiges Gerät, das räumlich getrennt von dem Multiturn-Drehgeber dieses Ausführungsbeispiels angeordnet ist. Beispielsweise handelt es sich um eine numerische Steuerung für Werkzeugmaschinen oder ein anderes Steuergerät der Automatisierungstechnik. Die Folgeelektronik 80 ist nicht Teil der vorliegenden Erfindung.

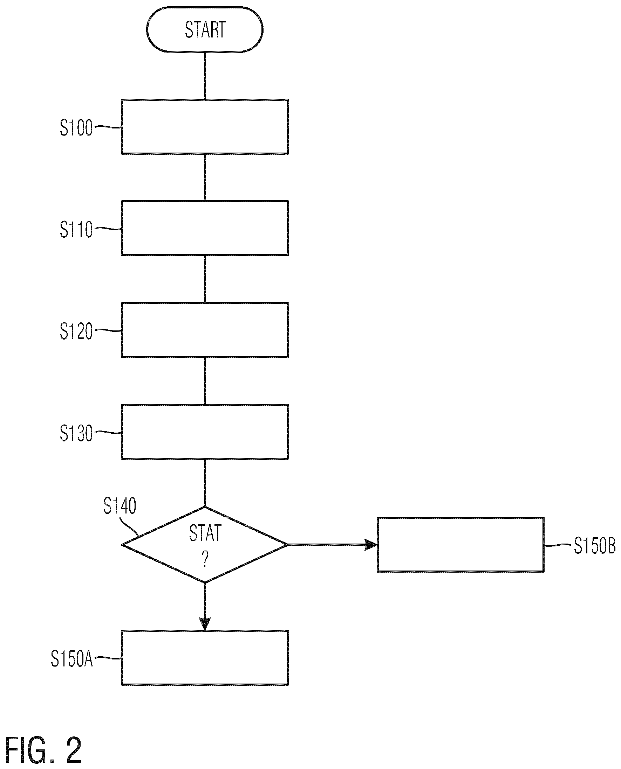

Figur 2 zeigt ein Ablaufdiagramm eines erfindungsgemäßen Verfahrens. Das Verfahren kann zu einem beliebigen Zeitpunkt während des Betriebs des Multiturn-Drehgebers durchgeführt werden. Mit Vorteil erfolgt die Durchführung unmittelbar nach dem Einschalten des Gerätes, um die Betriebsbereitschaft festzustellen. Gegebenenfalls wird vor dem Start des Verfahrens eine Initialisierung der ASICs 15, 25, 35, 45 durchgeführt.

In einem Schritt S100 sendet der übergeordnete ASIC 15 einen Selbsttest-Startbefehl ST an wenigstens einen untergeordneten ASIC 25, 35, 45. Je nach Teststrategie kann es vorteilhaft sein, den Selbsttest-Startbefehl ST an lediglich einen der untergeordneten ASICs 25, 35, 45 zu senden, nämlich dann, wenn gezielt die Betriebsbereitschaft dieses einen untergeordneten ASICs 25, 35, 45 festgestellt werden soll. Bevorzugt wird der Selbsttest-Startbefehl ST aber an alle erfindungsgemäß ausgestalteten untergeordneten ASICs 25, 35, 45 gesendet, so dass quasi gleichzeitig die Betriebsbereitschaft aller untergeordneten ASICs 25, 35, 45 festgestellt werden kann.

In einem Schritt S110 ermitteln diejenigen untergeordneten ASICs 25, 35, 45, die den Selbsttest-Startbefehl ST empfangen haben, die zur Feststellung der Betriebsbereitschaft notwendige Mehrzahl von Funktionsparametern Fn1, Fn2, Fn3. Der übergeordnete ASIC 15 wartet, bis die Ermittlung der Funktionsparameter Fn1, Fn2, Fn3 abgeschlossen ist. Wie oben beschrieben, kann dies durch Abwarten einer definierten Zeitspanne, durch Abfragen des Status der Ermittlung der Funktionsparameter Fn1, Fn2, Fn3, oder durch Warten auf das Eintreffen einer Abschlussmeldung der untergeordneten ASICs 25, 35, 45 erfolgen.

In einem Schritt S120 erfolgt die Übertragung der Funktionsparameter Fn1, Fn2, Fn3 über den Datenübertragungskanal 50 zum übergeordneten ASIC 15, insbesondere zur Diagnoseeinheit 16. Die Übertragung kann durch Senden von Datenanforderungsbefehlen RD1, RD2, RD3 an die jeweiligen untergeordneten ASICs 25, 35, 45 gestartet werden.

In einem Schritt S130 erfolgt die Auswertung der Funktionsparameter Fn1, Fn2, Fn3 und die Beurteilung der Funktionsbereitschaft des jeweiligen untergeordneten ASICs 25, 35, 45 durch die Diagnoseeinheit 16. Das Ergebnis der Auswertung wird in einer Statusinformation STAT gespeichert.

In einem Schritt S140 erfolgt anhand der Statusinformation STAT eine Entscheidung, ob in einen Normalbetrieb übergegangen werden kann (Schritt S150A) oder ob in einen Fehlerbetrieb übergegangen wird (Schritt S150B).

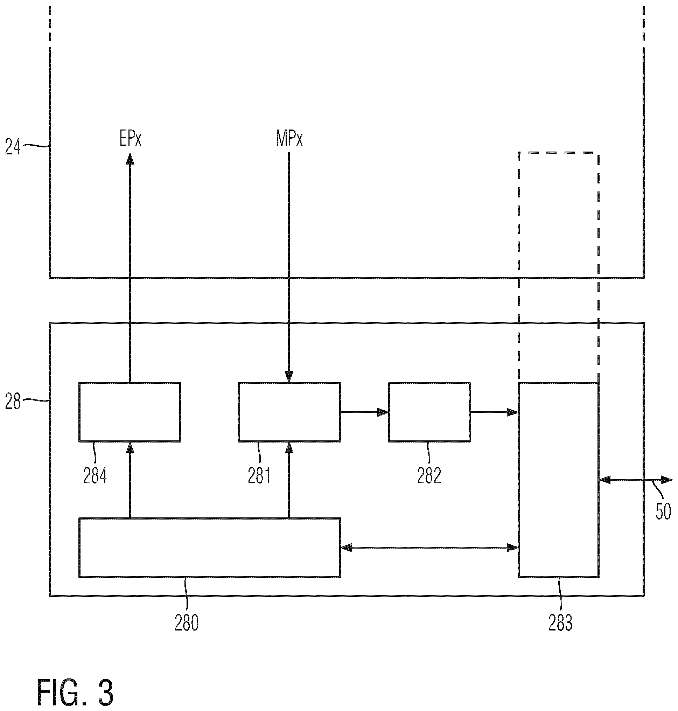

Figur 3 zeigt ein Blockschaltbild einer erfindungsgemäßen Parametermesseinheit. Sie wird anhand der Parametermesseinheit 28 der Figur 1 beschrieben, mit Vorteil sind aber die Parametermesseinheiten 28, 38, 48 identisch aufgebaut.

Die Parametermesseinheit 28 umfasst eine Ablaufsteuerung 280, Messmittel 281, einen Speicher 282 und eine Schnittstelleneinheit 283. Sie kann darüber hinaus wenigstens einen Signalerzeuger 284 umfassen.

Die Ablaufsteuerung 280 steuert den Ablauf der Selbsttestfunktion. Sie ist mit Vorteil als digitale Zustandsmaschine aufgebaut. Die Ablaufsteuerung 280 steuert die Messmittel 281, den Signalerzeuger 284 und ggf. den Speicher 282 entsprechend der Befehle, die ihr vom übergeordneten ASIC 15 über den Signalübertragungskanal 50 und die Schnittstelleneinheit 283 zugeführt werden. Sie ist außerdem geeignet ausgestaltet, um dem übergeordneten ASIC 15 über die Schnittstelleneinheit 283 und den Datenübertragungskanal 50 den Abschluss der Selbsttestfunktion, bzw. die Bereitstellung der Funktionsparameter Fn1 anzuzeigen.

Die Messmittel 281 dienen der Messung der Funktionsparameter Fn1. Sie sind hierzu mit wenigstens einem Messpunkt MPx der elektronischen Schaltung 24 des untergeordneten ASICs 25 verbunden. Die Messmittel 281 können zur Durchführung der Messungen einen A/D-Wandler, eine Zeitmesseinheit oder einen Komparator umfassen. Weiter können die Messmittel 281 Schaltelemente umfassen, um eine Mehrzahl von Messpunkten MPx für die Dauer der Messung zu den die Messungen durchführenden Einheiten zu verbinden.

Die von den Messmitteln 281 gemessenen Funktionsparameter Fn1 sind im Speicher 282 speicherbar und von der Schnittstelleneinheit 283 über den Datenübertragungskanal 50 zum übergeordneten ASIC 15 übertragbar.

Der Signalerzeuger 284 ist geeignet ausgestaltet, um wenigstens ein elektrisches Signal zu erzeugen und in wenigstens einen Einspeisepunkt EPx der elektronischen Schaltung 24 des untergeordneten ASICs 25 einzuspeisen. Signalerzeuger 284 können signalerzeugende Einheiten wie Spannungsquellen, D/A-Wandler und Taktgeneratoren umfassen. Beispiele für elektrische Signale sind Konstantspannungen und/oder -ströme, Wechselspannungen beliebiger Signalformen wie Sinusspannungen, Rechteckspannungen..., etc. Auch im Signalerzeuger 284 können Schaltelemente vorgesehen sein, um eine Mehrzahl von Einspeisepunkten EPx jeweils für die Dauer der Messung eines Funktionsparameters Fn1 mit der ein einzuspeisendes Signal erzeugenden Einheit im Signalerzeuger 284 zu verbinden.

Die Kommunikationseinheit 283 dient der Kommunikation der Parametermesseinheit 28 mit dem übergeordneten ASIC 15 über den Datenübertragungskanal 50. Die Kommunikation erfolgt bidirektional, so dass Befehle und/oder Daten vom übergeordneten ASIC 15 empfangen, sowie Daten, insbesondere Funktionsparameter Fn1, zum übergeordneten ASIC 15 übertragen werden können.

Wie durch die gestrichelt gezeichnete Linie dargestellt, ist es besonders vorteilhaft, wenn über die Schnittstelleneinheit 283 auch die Kommunikation der elektronischen Schaltung 24 des untergeordneten ASICs 25 mit der elektronischen Schaltung 14 des übergeordneten ASICs 15 erfolgt. Auf diese Weise ist nur eine einzige Schnittstellenverbindung zwischen dem untergeordneten ASIC 25 und dem übergeordneten ASIC 15 für den Selbsttestbetrieb und dem bestimmungsgemäßen Betrieb der ASICs erforderlich.

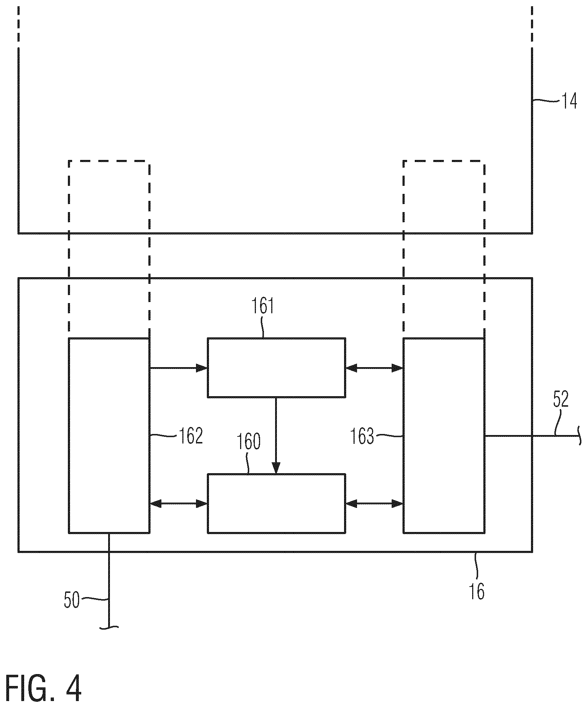

Figur 4 zeigt ein Blockschaltbild einer erfindungsgemäßen Diagnoseeinheit 16. Sie umfasst eine Diagnosesteuerung 160, eine Schnittstelleneinheit 162, sowie eine Geräteschnittstelle 163. Weiter kann die Diagnoseeinheit 16 eine einen Speicher 161 umfassen.

Die Diagnosesteuerung 160 steuert den Ablauf der Selbsttestfunktion. Hierzu startet sie die Ermittlung der Funktionsparameter Fn1, Fn2, Fn3 in den Parametermesseinheiten 28, 38, 48 der untergeordneten ASICs 25, 35, 45 durch Senden des Selbsttest-Startbefehls ST und initiiert die Übertragung der Funktionsparameter Fn1, Fn2, Fn3 durch Senden von Datenanforderungsbefehlen RD1, RD2, RD3. Die Übertragung der Befehle und Daten erfolgt jeweils über die Schnittstelleneinheit 162, den Datenübertragungskanal 50 und die Schnittstelleneinheit 283 der zu adressierenden Selbsttest-Einheit 28, 38, 48.

Die Diagnosesteuerung 160 ist geeignet ausgestaltet, die von den untergeordneten ASICs 25, 35, 45 eintreffenden Funktionsparameter Fn1, Fn2, Fn3 auf die Einhaltung von Grenzwerten zu prüfen und dadurch die Funktionsbereitschaft der untergeordneten ASICs 25, 35, 45 zu bewerten und zu entscheiden, ob in den Normalbetrieb oder den Fehlerbetrieb übergegangen wird. Die Grenzwerte können Ober- oder/und Untergrenzen von einzelnen Funktionsparametern, aber auch Abhängigkeiten zwischen zwei oder mehr der Funktionsparameter umfassen. Abhängigkeiten sind beispielsweise das Verhältnis von Eingangs- zu Ausgangssignalen von Verstärkerschaltungen, oder die Abhängigkeit der Momentanwerte von zueinander phasenverschobenen Signalen, insbesondere von in der Positionsmesstechnik häufig anzutreffenden um 90° zueinander phasenverschobenen sinusförmigen Sensorsignalen.

Das Ergebnis der Prüfung kann in einer Statusinformation STAT gespeichert und über die Geräteschnittstelle 163 und den externen Datenübertragungskanal 52 an die Folgeelektronik 80 ausgegeben werden.

Wie durch die gestrichelt gezeichneten Linien dargestellt und oben anhand der Schnittstelleneinheit 283 des untergeordneten ASICs 25 beschrieben, ist es besonders vorteilhaft, wenn über die Schnittstelleneinheit 162 auch die Kommunikation der elektronischen Schaltung 14 des übergeordneten ASICs 15 mit der elektronischen Schaltung 24, 34, 44 des jeweiligen untergeordneten ASICs 25, 35, 45 erfolgt.

Ebenso ist es vorteilhaft, wenn die Geräteschnittstelle 163 geeignet ausgestaltet ist, dass über sie nicht nur die Kommunikation der Diagnoseeinheit 16, sondern auch die Kommunikation der elektronischen Schaltung 14 des übergeordneten ASICs 15 mit der Folgeelektronik 80 erfolgt.

Der Speicher 161 kann dazu dienen, die Funktionsparameter Fn1, Fn2, Fn3 zu speichern, bevor sie von der Diagnosesteuerung 160 ausgewertet werden. Außerdem kann vorgesehen sein, dass die Funktionsparameter Fn1, Fn2, Fn3 vom Speicher 161 zur Folgeelektronik 80 übertragbar sind, so dass dort eine weitergehende Analyse eines Fehlerzustands möglich ist.

In einer weiteren vorteilhaften Ausgestaltung kann vorgesehen sein, dass in dem Speicher 161 die Grenzwerte und ggf. weitere Regeln für die Auswertung der Funktionsparameter Fn1, Fn2, Fn3 in der Diagnosesteuerung 160 speicherbar sind. Ist der Speicher 161 darüber hinaus beschreibbar ausgeführt, kann die Diagnoseeinheit 16 an verschiedene untergeordnete ASICs angepasst und der Selbsttest durchgeführt werden.

Als weitere vorteilhafte Funktionalität kann vorgesehen sein, dass der Speicher 282 der untergeordneten ASICs durch die Diagnoseeinheit 15 über den Datenübertragungskanal 50 beschreibbar und/oder löschbar ist. Auf diese Weise ist es möglich, die Funktion des Speichers 282 zu überprüfen.

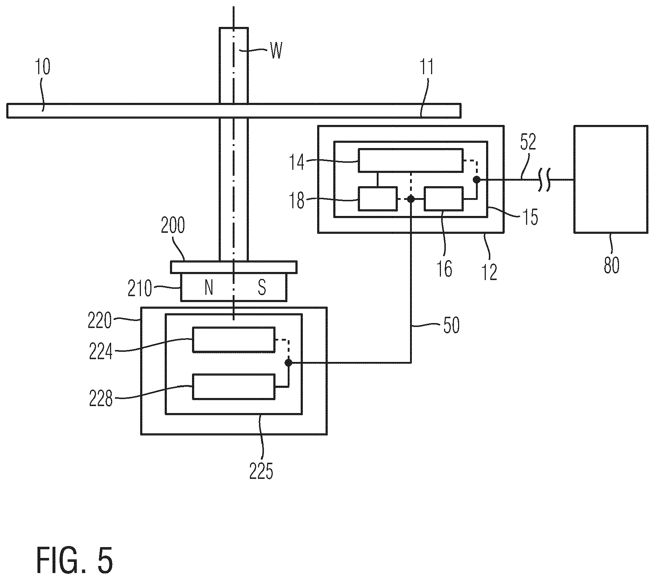

Figur 5 zeigt ein zweites Ausführungsbeispiel einer erfindungsgemäßen Schaltungsanordnung in Verbindung mit einem Multiturn-Drehgeber. Im Unterschied zum ersten Ausführungsbeispiel weist die Multiturn-Messanordnung des Multiturn-Drehgebers aber keinen getriebebasierten Umdrehungszähler, sondern einen elektronischen Umdrehungszähler auf.

Die Singleturn-Messanordnung entspricht der aus Figur 1, wobei darauf hingewiesen wird, dass sich die elektronische Schaltung 14 des übergeordneten ASICs 15 von der aus Figur 1 unterscheiden kann.

Die Multiturn-Messanordnung umfasst eine Multiturn-Codescheibe 200 mit einem Codeelement 210, sowie einen Multiturn-Positionsaufnehmer 220 zur Messung der Anzahl der zurückgelegten Umdrehungen der Welle W durch Messung und Auswertung der Winkelposition des mit der Welle W drehfest verbundenen Codeelements 210. Somit ist das Messprinzip äquivalent zu dem einer Multiturn-Stufe des Multiturn-Drehgebers aus Figur 1.

Der Multiturn-Positionsaufnehmer 220 besteht im Wesentlichen aus einem ASIC 225, in dem eine elektronische Schaltung 224 integriert ist, die der Ausführung der bestimmungsgemäßen Funktionen, insbesondere der Ermittlung der Anzahl der von der Welle W zurückgelegten Umdrehungen (Umdrehungsdaten) und deren Übertragung über den Datenübertragungskanal 50 zum Singleturn-Positionsaufnehmer 12, des ASICs dient. Der ASIC ist somit ein erfindungsgemäßer untergeordneter ASIC 225.

Um die Anzahl der Umdrehungen auch im ausgeschalteten Zustand des Multiturn-Drehgebers messen zu können, kann im Multiturn-Positionsaufnehmer 220 eine Batterie vorgesehen sein, die wenigstens die Teile der elektronischen Schaltung 224 mit Strom versorgt, die zur Umdrehungszählung benötigt werden. Alternativ zur Verwendung einer Batterie kann der Multiturn-Positionsaufnehmer 220 nach dem Prinzip des Energy Harvesting ausgeführt sein, beispielsweise unter Verwendung eines Wiegand-Drahtes.

Der untergeordnete ASIC 225 weist nun eine Parametermesseinheit 228 auf, die geeignet ausgestaltet ist, eine Mehrzahl von Funktionsparametern Fn4 zu ermitteln und über den Datenübertragungskanal 50 zur Diagnoseeinheit 16 im übergeordneten ASIC 15 zu übertragen. Hierzu kann die Parametermesseinheit 228 analog zur anhand der Figur 3 beschriebenen Parametermesseinheit aufgebaut sein.

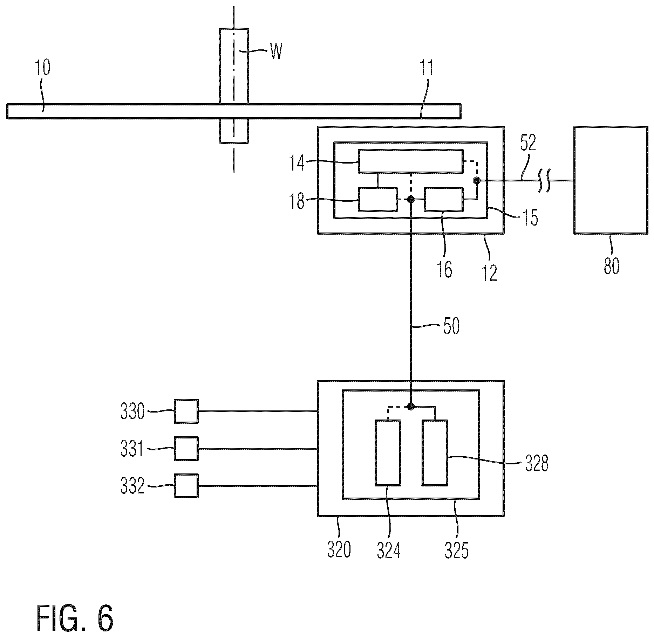

Figur 6 zeigt ein drittes Ausführungsbeispiel einer erfindungsgemäßen Schaltungsanordnung in Verbindung mit einem Singleturn-Drehgeber mit Zusatzsensoren. Zusatzsensoren kommen dann zum Einsatz, wenn ein Messgerät neben der primären Messaufgabe, in der Automatisierungstechnik beispielsweise die Messung der Winkelstellung und/oder der Anzahl zurückgelegter Umdrehungen einer Welle W, oder die Messung linearer Bewegungen eines Maschinenteils, noch zusätzliche Parameter innerhalb und/oder außerhalb des Messgerätes messen soll. Prominente Beispiele für derartige Parameter sind Temperatur, Beschleunigungen, Vibrationen und Luftfeuchte.

Die Singleturn-Messanordnung entspricht der aus Figur 1, wobei darauf hingewiesen wird, dass sich die elektronische Schaltung 14 des übergeordneten ASICs 15 von der aus Figur 1 unterscheiden kann, weil sie abweichende bestimmungsgemäße Funktionen aufweist.

Zur Erfassung von Messwerten wenigstens eines Zusatzsensors umfasst ist ein Sensordatenaufnehmer 320 vorgesehen, an den wenigstens ein, mit Vorteil aber eine Mehrzahl von Zusatzsensoren 330, 331, 332 anschließbar sind.

Der Sensordatenaufnehmer 320 besteht wiederum im Wesentlichen aus einem ASIC 325, in dem eine elektronische Schaltung 324 integriert ist, die der Ausführung der bestimmungsgemäßen Funktionen, insbesondere die Abfrage und ggf. Verarbeitung von Messdaten der Zusatzsensoren 330, 331, 332 und deren Übertragung über den Datenübertragungskanal 50 zum Singleturn-Positionsaufnehmer 12, des ASICs dient. Der ASIC ist somit ein erfindungsgemäßer untergeordneter ASIC 325.

Auch der untergeordnete ASIC 325 weist nun eine Parametermesseinheit 328 auf, die geeignet ausgestaltet ist, eine Mehrzahl von Funktionsparametern Fn5 zu ermitteln und über den Datenübertragungskanal 50 zur Diagnoseeinheit 16 im übergeordneten ASIC 15 zu übertragen. Hierzu kann die Parametermesseinheit 328 analog zur anhand der Figur 3 beschriebenen Parametermesseinheit 28 aufgebaut sein.

Es sei darauf hingewiesen, dass auch die anhand der Figuren 1 und 5 beschriebenen Ausführungsbeispiele durch einen Sensordatenaufnehmer 320 ergänzt werden können. Das bedeutet, dass die vorliegende Erfindung auch für Schaltungsanordnungen geeignet ist, die eine Mehrzahl von verschiedenen untergeordneten ASICs umfassen.

Deshalb ist es besonders vorteilhaft, wenn der übergeordnete ASIC 15, insbesondere dessen elektronische Schaltung 14, so ausgestaltet ist, dass er in mehreren Gerätevarianten und in Verbindung mit unterschiedlichen untergeordneten ASICs einsetzbar ist, beispielsweise in den Ausführungsbeispielen der Figuren 1, 5 und 6, sowie in Kombinationen hiervon.

Selbstverständlich ist die vorliegende Erfindung nicht auf die beschriebenen Ausführungsbeispiele eingeschränkt, sondern kann von einem Fachmann innerhalb des Schutzbereichs der Patentansprüche geeignet abgewandelt werden.

## Patentansprüche

1. Schaltungsanordnung, insbesondere für die Verwendung in Positionsmessgeräten, umfassend
• einen übergeordneten ASIC (15) mit einer elektronischen Schaltung (14) zur Ausführung einer bestimmungsgemäßen Funktion und
• wenigstens einen untergeordneten ASIC (25, 35, 45, 225, 325) mit einer elektronischen Schaltung (24, 34, 44, 224, 324) zur Ausführung einer bestimmungsgemäßen Funktion,
wobei der wenigstens eine untergeordnete ASIC (25, 35, 45, 225, 325) eine Parametermesseinheit (28, 38, 48, 228, 328) und der übergeordnete ASIC (15) eine Diagnoseeinheit (16) umfasst, die über einen Datenübertragungskanal (50) miteinander verbunden sind und wobei
• die Parametermesseinheit (28, 38, 48, 228, 328) ausgestaltet ist, um eine Mehrzahl von Funktionsparametern (Fn1, Fn2, Fn3, Fn4, Fn5) der elektronischen Schaltung (24, 34, 44, 224, 324) des untergeordneten ASICs (25, 35, 45, 225, 325) zu ermitteln und über den Datenübertragungskanal (50) zur Diagnoseeinheit (16) zu übertragen und
• die Diagnoseeinheit (16) ausgestaltet ist, durch Auswertung der Funktionsparameter (Fn1, Fn2, Fn3, Fn4, Fn5) die Funktionsbereitschaft der elektronischen Schaltung (24, 34, 44, 224, 324) des jeweiligen untergeordneten ASICs (25, 35, 45, 225, 325) festzustellen.

2. Schaltungsanordnung nach Anspruch 1, wobei die Parametermesseinheit (28, 38, 48, 228, 328) eine Ablaufsteuerung (280) zur Steuerung des Ablaufs der Selbsttestfunktion, Messmittel (281) zur Ermittlung der Funktionsparameter (Fn1, Fn2, Fn3, Fn4, Fn5) durch Messung an wenigstens einem Messpunkt (MPx) der elektronischen Schaltung (24, 34, 44, 224, 324) und eine Schnittstelleneinheit (283) zur Kommunikation mit dem übergeordneten ASIC (15) über den Datenübertragungskanal (50) umfasst.

3. Schaltungsanordnung nach einem der vorhergehenden Ansprüche, wobei die Parametermesseinheit (28, 38, 48, 228, 328) einen Speicher (282) umfasst, in dem die Funktionsparameter (Fn1, Fn2, Fn3, Fn4, Fn5) speicherbar sind.

4. Schaltungsanordnung nach Anspruch 3, wobei der Speicher (282) durch die Diagnoseeinheit (15) beschreibbar und/oder löschbar ist.

5. Schaltungsanordnung nach einem der vorhergehenden Ansprüche, wobei die Parametermesseinheit (28, 38, 48, 228, 328) wenigstens einen Signalerzeuger (284) zur Erzeugung wenigstens eines elektrischen Signals und zu dessen Einspeisung in wenigstens einen Einspeisepunkt (EPx) der elektronischen Schaltung (24, 34, 44, 224, 324) umfasst.

6. Schaltungsanordnung nach einem der vorhergehenden Ansprüche, wobei die Diagnoseeinheit (16) eine Diagnosesteuerung (160) zur Steuerung des Ablaufs der Selbsttestfunktion, eine Schnittstelleneinheit (162) zur Kommunikation mit den jeweiligen Parametermesseinheiten (28, 38, 48, 228, 328) über den Datenübertragungskanal (50), sowie eine Geräteschnittstelle (163) zur Kommunikation mit einer Folgeelektronik (80) über einen externen Datenübertragungskanal (52) umfasst.

7. Schaltungsanordnung nach einem der vorhergehenden Ansprüche, wobei die Diagnoseeinheit (16) einen Speicher (161) umfasst, in dem die Funktionsparameter (Fn1, Fn2, Fn3, Fn4, Fn5) oder/und Grenzwerte für die Auswertung der Funktionsparameter (Fn1, Fn2, Fn3, Fn4, Fn5) oder/und weitere Regeln für die Auswertung der Funktionsparameter (Fn1, Fn2, Fn3, Fn4, Fn5) speicherbar sind.

8. Verfahren zum Betreiben einer Schaltungsanordnung, insbesondere für die Verwendung in Positionsmessgeräten, umfassend
• einen übergeordneten ASIC (15) mit einer elektronischen Schaltung (14) zur Ausführung einer bestimmungsgemäßen Funktion und
• wenigstens einen untergeordneten ASIC (25, 35, 45, 225, 325) mit einer elektronischen Schaltung (24, 34, 44, 224, 324) zur Ausführung einer bestimmungsgemäßen Funktion,
wobei der wenigstens eine untergeordnete ASIC (25, 35, 45, 225, 325) eine Parametermesseinheit (28, 38, 48, 228, 328) und der übergeordnete ASIC (15) eine Diagnoseeinheit (16) umfasst, die über einen Datenübertragungskanal (50) miteinander verbunden sind, mit folgenden Schritten:
• Ermittlung einer Mehrzahl von Funktionsparametern (Fn1, Fn2, Fn3, Fn4, Fn5) der elektronischen Schaltung (24, 34, 44, 224, 324) des untergeordneten ASICs (25, 35, 45, 225, 325) und Übertragung der Mehrzahl von Funktionsparametern (Fn1, Fn2, Fn3, Fn4, Fn5) über den Datenübertragungskanal (50) zur Diagnoseeinheit (16) durch die Parametermesseinheit (28, 38, 48, 228, 328) und
• Feststellung der Funktionsbereitschaft der elektronischen Schaltung (24, 34, 44, 224, 324) des jeweiligen untergeordneten ASICs (25, 35, 45, 225, 325) durch Auswertung der Funktionsparameter (Fn1, Fn2, Fn3, Fn4, Fn5) in der Diagnoseeinheit (16).

9. Verfahren nach Anspruch 8, wobei die Parametermesseinheit (28, 38, 48, 228, 328) eine Ablaufsteuerung (280), Messmittel (281) und eine Schnittstelleneinheit (283) umfasst, wobei
• von der Ablaufsteuerung (280) der Ablauf der Selbsttestfunktion gesteuert wird,
• von den Messmitteln (281) durch Messung die Funktionsparameter (Fn1, Fn2, Fn3, Fn4, Fn5) an wenigstens einem Messpunkt (MPx) der elektronischen Schaltung (24, 34, 44, 224, 324) ermittelt werden und
• über die Schnittstelleneinheit (283) mit dem übergeordneten ASIC (15) über den Datenübertragungskanal (50) kommuniziert wird.

10. Verfahren nach einem der Ansprüche 8 oder 9, wobei die Parametermesseinheit (28, 38, 48, 228, 328) einen Speicher (282) umfasst, in dem die Funktionsparameter (Fn1, Fn2, Fn3, Fn4, Fn5) gespeichert werden.

11. Verfahren nach Anspruch 10, wobei der Speicher (282) durch die Diagnoseeinheit (15) beschrieben und/oder gelöscht wird.

12. Verfahren nach einem der Ansprüche 8 bis 11, wobei die Parametermesseinheit (28, 38, 48, 228, 328) wenigstens einen Signalerzeuger (284) umfasst, von dem wenigstens ein elektrisches Signal erzeugt und in wenigstens einen Einspeisepunkt (EPx) der elektronischen Schaltung (24, 34, 44, 224, 324) eingespeist wird.

13. Verfahren nach einem der Ansprüche 8 bis 12, wobei die Diagnoseeinheit (16) eine Diagnosesteuerung (160), eine Schnittstelleneinheit (162), sowie eine Geräteschnittstelle (163) umfasst, wobei
• von der Diagnosesteuerung (160) der Ablauf der Selbsttestfunktion gesteuert wird,
• über die Schnittstelleneinheit (162) mit den jeweiligen Parametermesseinheiten (28, 38, 48, 228, 328) über den Datenübertragungskanal (50) kommuniziert wird und
• über die Geräteschnittstelle (163) mit einer Folgeelektronik (80) über einen externen Datenübertragungskanal (52) kommuniziert wird.

14. Verfahren nach einem der Ansprüche 8 bis 13, wobei die Diagnoseeinheit (16) einen Speicher (161) umfasst, in dem die Funktionsparameter (Fn1, Fn2, Fn3, Fn4, Fn5) oder/und Grenzwerte für die Auswertung der Funktionsparameter (Fn1, Fn2, Fn3, Fn4, Fn5) oder/und weitere Regeln für die Auswertung der Funktionsparameter (Fn1, Fn2, Fn3, Fn4, Fn5) gespeichert werden.

15. Positionsmessgerät, umfassend eine Schaltungsanordnung nach einem der Ansprüche 1 bis 7.

## Claims

1. Circuit arrangement, in particular for use in position measuring devices, comprising
• a superordinate ASIC (15) with an electronic circuit (14) for performing an intended function and
• at least one subordinate ASIC (25, 35, 45, 225, 325) with an electronic circuit (24, 34, 44, 224, 324) for performing an intended function,
wherein the at least one subordinate ASIC (25, 35, 45, 225, 325) comprises a parameter measuring unit (28, 38, 48, 228, 328) and the superordinate ASIC (15) comprises a diagnostic unit (16), which are connected to one another via a data transmission channel (50), and wherein
• the parameter measuring unit (28, 38, 48, 228, 328) is designed to ascertain a plurality of functional parameters (Fnl, Fn2, Fn3, Fn4, Fn5) of the electronic circuit (24, 34, 44, 224, 324) of the subordinate ASIC (25, 35, 45, 225, 325) and to transmit them to the diagnostic unit (16) via the data transmission channel (50) and
• the diagnostic unit (16) is designed to determine the functional readiness of the electronic circuit (24, 34, 44, 224, 324) of the respective subordinate ASIC (25, 35, 45, 225, 325) by evaluating the functional parameters (Fnl, Fn2, Fn3, Fn4, Fn5).

2. Circuit arrangement according to Claim 1, wherein the parameter measuring unit (28, 38, 48, 228, 328) comprises a sequence controller (280) for controlling the sequence of the self-test function, measuring means (281) for ascertaining the functional parameters (Fnl, Fn2, Fn3, Fn4, Fn5) by measuring at at least one measuring point (MPx) of the electronic circuit (24, 34, 44, 224, 324) and an interface unit (283) for communicating with the superordinate ASIC (15) over the data transmission channel (50).

3. Circuit arrangement according to either of the preceding claims, wherein the parameter measuring unit (28, 38, 48, 228, 328) comprises a memory (282) in which the functional parameters (Fnl, Fn2, Fn3, Fn4, Fn5) are able to be stored.

4. Circuit arrangement according to Claim 3, wherein the diagnostic unit (15) is able to write to and/or delete from the memory (282).

5. Circuit arrangement according to one of the preceding claims, wherein the parameter measuring unit (28, 38, 48, 228, 328) comprises at least one signal generator (284) for generating at least one electrical signal and for feeding it into at least one feed-in point (EPx) of the electronic circuit (24, 34, 44, 224, 324).

6. Circuit arrangement according to one of the preceding claims, wherein the diagnostic unit (16) comprises a diagnostic controller (160) for controlling the sequence of the self-test function, an interface unit (162) for communicating with the respective parameter measuring units (28, 38, 48, 228, 328) over the data transmission channel (50), and a device interface (163) for communicating with downstream electronics (80) over an external data transmission channel (52).

7. Circuit arrangement according to one of the preceding claims, wherein the diagnostic unit (16) comprises a memory (161) in which the functional parameters (Fnl, Fn2, Fn3, Fn4, Fn5) and/or limit values for the evaluation of the functional parameters (Fnl, Fn2, Fn3, Fn4, Fn5) and/or further rules for the evaluation of the functional parameters (Fnl, Fn2, Fn3, Fn4, Fn5) are able to be stored.

8. Method for operating a circuit arrangement, in particular for use in position measuring devices, comprising
• a superordinate ASIC (15) with an electronic circuit (14) for performing an intended function and
• at least one subordinate ASIC (25, 35, 45, 225, 325) with an electronic circuit (24, 34, 44, 224, 324) for performing an intended function,
wherein the at least one subordinate ASIC (25, 35, 45, 225, 325) comprises a parameter measuring unit (28, 38, 48, 228, 328) and the superordinate ASIC (15) comprises a diagnostic unit (16), which are connected to one another via a data transmission channel (50), comprising the following steps:
• ascertaining a plurality of functional parameters (Fnl, Fn2, Fn3, Fn4, Fn5) of the electronic circuit (24, 34, 44, 224, 324) of the subordinate ASIC (25, 35, 45, 225, 325) and transmitting the plurality of functional parameters (Fnl, Fn2, Fn3, Fn4, Fn5) to the diagnostic unit (16) via the data transmission channel (50) by way of the parameter measuring unit (28, 38, 48, 228, 328) and
• determining the functional readiness of the electronic circuit (24, 34, 44, 224, 324) of the respective subordinate ASIC (25, 35, 45, 225, 325) by evaluating the functional parameters (Fnl, Fn2, Fn3, Fn4, Fn5) in the diagnostic unit (16).

9. Method according to Claim 8, wherein the parameter measuring unit (28, 38, 48, 228, 328) comprises a sequence controller (280), measuring means (281) and an interface unit (283), wherein
• the sequence of the self-test function is controlled by the sequence controller (280),
• the functional parameters (Fnl, Fn2, Fn3, Fn4, Fn5) are ascertained at at least one measuring point (MPx) of the electronic circuit (24, 34, 44, 224, 324) by way of measurement by the measuring means (281) and
• communication is made with the superordinate ASIC (15) over the data transmission channel (50) via the interface unit (283).

10. Method according to either of Claims 8 and 9, wherein the parameter measuring unit (28, 38, 48, 228, 328) comprises a memory (282) in which the functional parameters (Fnl, Fn2, Fn3, Fn4, Fn5) are stored.

11. Method according to Claim 10, wherein the diagnostic unit (15) writes to and/or deletes from the memory (282).

12. Method according to one of Claims 8 to 11, wherein the parameter measuring unit (28, 38, 48, 228, 328) comprises at least one signal generator (284) that generates at least one electrical signal and feeds it into at least one feed-in point (EPx) of the electronic circuit (24, 34, 44, 224, 324).

13. Method according to one of Claims 8 to 12, wherein the diagnostic unit (16) comprises a diagnostic controller (160), an interface unit (162), and a device interface (163), wherein
• the sequence of the self-test function is controlled by the diagnostic controller (160),
• communication is made with the respective parameter measuring units (28, 38, 48, 228, 328) over the data transmission channel (50) via the interface unit (162) and
• communication is made with downstream electronics (80) over an external data transmission channel (52) via the device interface (163).

14. Method according to one of Claims 8 to 13, wherein the diagnostic unit (16) comprises a memory (161) in which the functional parameters (Fnl, Fn2, Fn3, Fn4, Fn5) and/or limit values for the evaluation of the functional parameters (Fnl, Fn2, Fn3, Fn4, Fn5) and/or further rules for the evaluation of the functional parameters (Fnl, Fn2, Fn3, Fn4, Fn5) are stored.

15. Position measuring device, comprising a circuit arrangement according to one of Claims 1 to 7.

## Revendications

1. Agencement de circuit, en particulier pour utilisation dans des dispositifs de mesure de position, comprenant
• un ASIC supérieur (15) comprenant un circuit électronique (14) pour exécuter une fonction conforme à sa destination, et
• au moins un ASIC subordonné (25, 35, 45, 225, 325) comprenant un circuit électronique (24, 34, 44, 224, 324) pour exécuter une fonction conforme à sa destination,
dans lequel l'au moins un ASIC subordonné (25, 35, 45, 225, 325) comprend une unité de mesure de paramètres (28, 38, 48, 228, 328) et l'ASIC supérieur (15) comprend une unité de diagnostic (16), lesquelles sont reliées entre elles par l'intermédiaire d'un canal de transmission de données (50) et dans lequel
• l'unité de mesure des paramètres (28, 38, 48, 228, 328) est configurée pour déterminer une pluralité de paramètres de fonction (Fnl, Fn2, Fn3, Fn4, Fn5) du circuit électronique (24, 34, 44, 224, 324) de l'ASIC subordonné (25, 35, 45, 225, 325) et pour les transmettre à l'unité de diagnostic (16) par l'intermédiaire du canal de transmission de données (50), et
• l'unité de diagnostic (16) est configurée pour obtenir, par évaluation des paramètres de fonction (Fn1, Fn2, Fn3, Fn4, Fn5), l'aptitude au fonctionnement du circuit électronique (24, 34, 44, 224, 324) de l'ASIC subordonné (25, 35, 45, 225, 325) respectif.

2. Agencement de circuit selon la revendication 1, dans lequel l'unité de mesure de paramètres (28, 38, 48, 228, 328) comprend une commande séquentielle (280) pour commander le déroulement de la fonction d'autotest, des moyens de mesure (281) pour déterminer les paramètres de fonction (Fn1, Fn2, Fn3, Fn4, Fn5) par mesure au niveau d'au moins un point de mesure (MPx) du circuit électronique (24, 34, 44, 224, 324), et une unité d'interface (283) pour la communication avec l'ASIC supérieur (15) par l'intermédiaire du canal de transmission de données (50).

3. Agencement de circuit selon l'une quelconque des revendications précédentes, dans lequel l'unité de mesure de paramètres (28, 38, 48, 228, 328) comprend une mémoire (282) dans laquelle peuvent être mémorisés les paramètres de fonction (Fnl, Fn2, Fn3, Fn4, Fn5).

4. Agencement de circuit selon la revendication 3, dans lequel la mémoire (282) peut être écrite et/ou effacée par l'unité de diagnostic (15).

5. Agencement de circuit selon l'une quelconque des revendications précédentes, dans lequel l'unité de mesure de paramètres (28, 38, 48, 228, 328) comprend au moins un générateur de signaux (284) pour générer au moins un signal électrique et pour l'injecter dans au moins un point d'injection (EPx) du circuit électronique (24, 34, 44, 224, 324).

6. Agencement de circuit selon l'une quelconque des revendications précédentes, dans lequel l'unité de diagnostic (16) comprend une commande de diagnostic (160) pour commander le déroulement de la fonction d'autotest, une unité d'interface (162) pour la communication avec les unités de mesure de paramètres (28, 38, 48, 228, 328) respectives par l'intermédiaire du canal de transmission de données (50), ainsi qu'une interface d'appareil (163) pour la communication avec une électronique de suivi (80) par l'intermédiaire d'un canal de transmission de données externe (52).

7. Agencement de circuit selon l'une quelconque des revendications précédentes, dans lequel l'unité de diagnostic (16) comprend une mémoire (161) dans laquelle peuvent être mémorisés les paramètres de fonction (Fnl, Fn2, Fn3, Fn4, Fn5) et/ou des valeurs limites pour l'évaluation des paramètres de fonction (Fnl, Fn2, Fn3, Fn4, Fn5) et/ou d'autres règles pour l'évaluation des paramètres de fonction (Fnl, Fn2, Fn3, Fn4, Fn5).

8. Procédé pour faire fonctionner un agencement de circuit, en particulier pour utilisation dans des dispositifs de mesure de position, comprenant
• un ASIC supérieur (15) comprenant un circuit électronique (14) pour exécuter une fonction conforme à sa destination, et
• au moins un ASIC subordonné (25, 35, 45, 225, 325) comprenant un circuit électronique (24, 34, 44, 224, 324) pour exécuter une fonction conforme à sa destination,
dans lequel l'au moins un ASIC subordonné (25, 35, 45, 225, 325) comprend une unité de mesure de paramètres (28, 38, 48, 228, 328) et l'ASIC supérieur (15) comprend une unité de diagnostic (16), lesquelles sont reliées entre elles par l'intermédiaire d'un canal de transmission de données (50), avec les étapes suivantes :
• détermination d'une pluralité de paramètres de fonction (Fnl, Fn2, Fn3, Fn4, Fn5) du circuit électronique (24, 34, 44, 224, 324) de l'ASIC subordonné (25, 35, 45, 225, 325) et transmission de la pluralité de paramètres de fonction (Fnl, Fn2, Fn3, Fn4, Fn5) par l'intermédiaire du canal de transmission de données (50) à l'unité de diagnostic (16) par l'unité de mesure de paramètres (28, 38, 48, 228, 328) et
• obtention de l'aptitude au fonctionnement du circuit électronique (24, 34, 44, 224, 324) de l'ASIC subordonné (25, 35, 45, 225, 325) respectif par évaluation des paramètres de fonction (Fn1, Fn2, Fn3, Fn4, Fn5) dans l'unité de diagnostic (16).

9. Procédé selon la revendication 8, dans lequel l'unité de mesure de paramètres (28, 38, 48, 228, 328) comprend une commande séquentielle (280), des moyens de mesure (281) et une unité d'interface (283), dans lequel
• le déroulement de la fonction d'autotest est commandé par la commande séquentielle (280),
• les paramètres de fonctionnement (Fn1, Fn2, Fn3, Fn4, Fn5) sont déterminés par les moyens de mesure (281) par mesure au niveau d'au moins un point de mesure (MPx) du circuit électronique (24, 34, 44, 224, 324) et
• une communication est établie via l'unité d'interface (283) avec l'ASIC supérieur (15) par l'intermédiaire du canal de transmission de données (50).

10. Procédé selon l'une quelconque des revendications 8 ou 9, dans lequel l'unité de mesure de paramètres (28, 38, 48, 228, 328) comprend une mémoire (282) dans laquelle sont mémorisés les paramètres de fonction (Fn1, Fn2, Fn3, Fn4, Fn5).

11. Procédé selon la revendication 10, dans lequel la mémoire (282) est écrite et/ou effacée par l'unité de diagnostic (15).

12. Procédé selon l'une quelconque des revendications 8 à 11, dans lequel l'unité de mesure de paramètres (28, 38, 48, 228, 328) comprend au moins un générateur de signaux (284), par lequel au moins un signal électrique est généré et envoyé à au moins un point d'alimentation (EPx) du circuit électronique (24, 34, 44, 224, 324).

13. Procédé selon l'une quelconque des revendications 8 à 12, dans lequel l'unité de diagnostic (16) comprend une commande de diagnostic (160), une unité d'interface (162) ainsi qu'une interface d'appareil (163), dans lequel
• le déroulement de la fonction d'autotest est commandé par la commande de diagnostic (160),
• une communication est établie via l'unité d'interface (162) avec les unités de mesure de paramètres (28, 38, 48, 228, 328) respectives par l'intermédiaire du canal de transmission de données (50) et
• une communication est établie via l'interface d'appareil (163) avec une électronique de suivi (80) par l'intermédiaire d'un canal de transmission de données externe (52).

14. Procédé selon l'une quelconque des revendications 8 à 13, dans lequel l'unité de diagnostic (16) comprend une mémoire (161) dans laquelle sont mémorisés les paramètres de fonction (Fn1, Fn2, Fn3, Fn4, Fn5) et/ou des valeurs limites pour l'évaluation des paramètres de fonction (Fn1, Fn2, Fn3, Fn4, Fn5) et/ou d'autres règles pour l'évaluation des paramètres de fonction (Fnl, Fn2, Fn3, Fn4, Fn5).

15. Dispositif de mesure de position, comprenant un agencement de circuit selon l'une quelconque des revendications 1 à 7.
